# EUROPEAN PATENT APPLICATION

(11) **EP 3 369 483 A1**
(43) Date of publication of application: **05.09.2018**
(21) Application number: 17159079.7
(22) Date of filing: 03.03.2017
(51) Int. Cl.: B01L 3/00, B32B 27/28, B32B 7/02, B81C 1/00, G01N 37/00

(54) **IMPROVED MICROFLUIDIC DEVICES AND METHODS TO OBTAIN THEM**

(71) Applicant: Fraunhofer-Gesellschaft zur Förderung der angewandten Forschung e.V., 80686 München (DE)
(72) Inventor: HAUPT, Michael, 73326 Deggingen (DE); LOSKILL, Peter, 70199 Stuttgart (DE)
(74) Representative: Schrell, Andreas

(57) **Abstract**

A polymeric device, in particular microfluidic device (100), cell culture system or membrane comprising a system (20) of microchannels (25), wells and/or pores, in a polymeric device (10), wherein at least a part of the surface area of the microchannels (25) is formed by an absorption barrier layer system, wherein the absorption barrier layer system comprises at least one polymeric interface layer (40) and at least one barrier coating layer (50).

## Description

The present invention relates to coated polymeric devices, in particular microfluidic devices, cell culture devices and membranes, processes for preparing them and uses thereof.

Polymeric systems, in particular microfluidic systems are well known and have in the past attracted increasing interest, in particular due to their widespread and diverse potential applications, ranging from cell culture devices, membranes and DNA chips to inkjet printheads. Microfluidic devices are characterised by a network or system of microchannels arranged, in particular moulded or patterned in a substrate. They are characterised by a small size and very small sample volumes in femto-, pico-, nano- or µl-range. Microfluidic devices, thus, allow using extremely small volumes of samples, they allow carrying out complex biochemical reactions for obtaining biological, medical and chemical information, they have the advantage to reduce the required amount of samples, they shorten the response time of reactions, they decrease the amount of biohazard and waste for disposal and they safe money. In particular, microfluidic devices are for use in lab-on-a-chip and organ-on-a-chip systems, allowing testing of potential drugs, cosmetic agents, dyes, biomarkers or other molecules characteristics which can be tested on tissues or cells.

Early microfluidic devices were fabricated in silicon and glass using photolithography and etching techniques adapted from the microelectronic industry. Nowadays, microfluidic devices are made from plastic, polymeric materials and glass. Polymeric materials frequently used for the construction of microfluidic devices include PDMS (polydimethylsiloxane). These materials allow to design microfluidic devices with improved specific optical characteristics, biological or chemical compatibility, faster prototyping, lower production costs and they allow electrosensing.

Accordingly, US 2012/0181184 A1 discloses microfluidic devices comprises porous hydrophilic layers for the analysis of various analyst in a sample. US 2012/0168010 discloses methods of layer-by-layer deposition of a plurality of layers of material onto the wall of a channel of a microfluidic device, involving injecting solutions into the microfluidic device.

However, one major problem polymeric devices, in particular cell culture devices, membranes and microfluidic devices, frequently encounter is partitioning of molecules, in particular hydrophobic molecules, from the sample contained on the surface of the polymeric device, for instance in the microchannels of a microfluidic device, into the polymeric material forming the polymeric device, for instance the microfluidic device. The absorption of said molecules into the polymeric device, in particular the microfluidic device, causes manifold problems. In particular, since the substances which penetrated into the polymeric device, in particular the microfluidic device, and have been absorbed thereby are missing in the sample, an unknown concentration thereof in the sample is resulting. Furthermore, in the further process of analysing the sample, an uncontrolled release of the substances being absorbed from the substrate back into the sample may cause further concentration and evaluation problems. Also, other substances, for instance biomarkers, used in the sample may be absorbed by the polymeric device, in particular the microfluidic device, thereby hindering the detection of substances in the sample.

Thus, the technical problem underlying the present invention is to provide a polymeric device, in particular microfluidic device, cell culture device or membrane, and a process for producing it, overcoming the above identified technical problems, in particular which shows no or a reduced absorption of substances contained in a sample into the material of the polymeric device, in particular microfluidic device, cell culture device or membrane.

The present invention solves the above identified problem by providing a coated polymeric device comprising at least on a part of the surface of a polymeric device an absorption barrier layer system, wherein the absorption barrier layer system comprises at least one polymeric interface layer and at least one barrier coating layer.

In the context of the present invention a polymeric device is preferably a microfluidic device, a membrane or a cell culture device.

In a preferred embodiment of the present invention, the polymeric device is a microfluidic device.

In a furthermore preferred embodiment of the present invention, the polymeric device is a membrane.

In a preferred embodiment, the polymeric device is a cell culture device, wherein the cell culture device is preferably a matrix, a sheet, a plate, a carrier, a carrier plate or a dish.

In a preferred embodiment of the present invention, the polymeric device according to the present invention comprises at least one topographical structure.

Preferably, the topographical structure is a three-dimensional structure, for instance a system of pores, a system of microchannels or a system of wells or a combination thereof, in particular a pore, a microchannel and/or a well, wherein at least one of the dimensions of said topographical structure has an internal cross-sectional dimension (that means depth, width or length) of less than 1000 µm, in particular has at least one diameter in the range from 0.1 to 990 µm, preferably 0.5 to 900 µm, in particular 0.5 to 800 µm, preferably 1 to 400 µm, preferably 1 to 10 µm, preferably 1 to 5 µm.

In a furthermore preferred embodiment of the present invention, the polymeric device does not comprise a topographical structure that means has no system of pores, no system of microchannels and/or system of wells.

Accordingly, the present invention provides the teaching to provide an absorption barrier layer system as defined above, being present on at least a part of the surface of the polymeric device so as to provide a coated polymeric device.

The absorption barrier layer system may be present on the complete surface of the polymeric device. The absorption barrier layer system may, however, in another embodiment be present on solely part of the polymeric device. In a preferred embodiment, the absorption barrier layer system is present solely on the surface of the topographical structure that means in particular solely on the surface of the system of microchannels, pores, and/or wells. In another embodiment, the absorption barrier layer system is present both on the surface of the topographical structure and the residual surface of the polymeric device. In another preferred embodiment, the absorption barrier layer system is present solely on those surface areas of the polymeric device which do not form the surface of a topographical structure.

In a preferred embodiment, the present invention solves the above identified problem by providing a microfluidic device, comprising a system of microchannels in a polymeric device, wherein at least a part of the surface of the microchannels is formed by an absorption barrier layer system, wherein the absorption barrier layer system comprises at least one polymeric interface layer and at least one barrier coating layer.

In one preferred embodiment of the present invention, the at least one polymeric interface layer is deposited on the surface of the polymeric device, in particular of the pores, wells and/or microchannels, and the at least one barrier coating layer is deposited on the polymeric interface layer. Further preferred embodiments comprise an absorption barrier layer system which comprises 2, 3, 4, 5, 6, 7, 8, 9, 10 or more barrier coating layers each of them separated from the other by an intervening polymeric interface layer, wherein the first of these barrier coating layers is either deposited on the surface of the polymeric device, in particular of the pores, wells and/or microchannels, or on a polymeric interface layer being itself deposited on the surface of the polymeric device, in particular of the pores, wells and/or microchannels.

In a furthermore preferred embodiment, the at least one polymeric interface layer and the at least one barrier coating layer is deposited on the surface of the polymeric device, in particular of the pores, wells and/or microchannels, which surface of the polymeric device, in particular of the pores, wells and/or microchannels, is formed by a crosslinked superficial section of the polymeric device.

A crosslinked superficial section of the polymeric device as referred to herein is a superficial section or area of the polymeric device which has been subjected to a particular crosslinking process step, in particular a plasma-, preferably low pressure plasma- process step involving UV- and/or VUV-radiation so as to provide an additional absorption barrier structure. Thus, the presently referred to crosslinked superficial section of the polymeric device is a particular superficial section of the polymeric device having been subjected to such a process step. In the context of the present invention, a crosslinking process which is performed to prepare the polymeric device from the starting material, that means the polymer precursors, is a crosslinking referring to prepare the polymeric device itself and is not considered to relate to the formation of the particular preferred crosslinked superficial section of the polymeric device which latter has been obtained by subjecting a prepared polymeric device to a particular surface-crosslinking process, in particular plasma-based UV/VUV process for obtaining a crosslinked section solely in the superficial area of polymeric device.

Further preferred embodiments comprise an absorption barrier layer system which comprises 2, 3, 4, 5, 6, 7, 8, 9, 10 or more barrier coating layers each of them separated from the other by an intervening polymeric interface layer, wherein the first of these barrier coating layers is either deposited on the surface of the polymeric device, in particular of the pores, wells and/or microchannels, or on a polymeric interface layer deposited on the surface of the polymeric device, in particular of the pores, wells and/or microchannels, wherein all of these layers are located on a crosslinked superficial section of the polymeric device.

Thus, in the context of the present invention, the absorption barrier layer system comprises at least one polymeric interface layer and at least one barrier coating layer, preferably the absorption barrier layer system comprises at least one polymeric interface layer and at least one barrier coating layer and a surface of the polymeric device, in particular of the pores, wells and/or microchannels, which is a crosslinked superficial section of the polymeric device.

The present invention, thus, provides a coated polymeric device, in particular microfluidic device, which device is made from a polymeric substrate, for instance polydimethylsiloxane (PDMS). In a preferred embodiment, wherein the polymeric device is a microfluidic device a system of microchannels is located in the polymeric device. Preferably. at least part of the surface of said microchannels, in particular the complete surface of the microchannels, is formed by an absorption barrier layer system comprising at least one polymeric interface layer and at least one barrier coating layer.

The presently provided absorption barrier layer system is called herein also a hybrid multilayered absorption barrier layer system. The present absorption barrier layer system provides a barrier for partitioning of molecules contained in a sample, for instance a sample to be tested, cultivated or analysed and being provided on the polymeric device, in particular in the pores, wells and/or microchannels, for instance of a membrane, a cell culture device or a microfluidic device, into the material of the polymeric device itself. The absorption barrier layer system of the present invention, thus, provides a protection against partitioning of substances, in particular hydrophobic substances, from a sample into the material of the polymeric device.

The absorption barrier layer system comprises in one embodiment one or more barrier coating layers, which are deposited on the surface of the polymeric device, in particular pores, wells and/or microchannels, or on a crosslinked superficial section of the polymeric device.

In case the absorption barrier layer system comprises one barrier coating layer, said barrier coating layer is deposited on a polymeric interface layer, which deposited polymeric interface layer is deposited on the surface of the polymeric device, in particular pores, wells and/or microchannels, or deposited on the crosslinked superficial section of the polymeric device. In case the absorption barrier layer system comprises two or more barrier coating layers, then each of said barrier coating layers is separated from the other by an intervening polymeric interface layer, the number of which depends upon the number of the barrier coating layers to be separated from each other and wherein either the first barrier coating layer is directly deposited on the surface area of the polymeric device, in particular pores, wells and/or microchannels, or on a crosslinked superficial section of the polymeric device or wherein the first barrier coating layer is deposited on a polymeric interface layer which polymeric interface layer either is being deposited on the surface of the polymeric device, in particular pores, wells and/or microchannels, or on a crosslinked superficial section of the polymeric device.

Thus, in a preferred embodiment, the absorption barrier layer system comprises at least one barrier coating layer deposited on a polymeric interface layer which polymeric interface layer is deposited on the surface of the polymeric device, in particular pores, wells and/or microchannels. In a furthermore preferred embodiment, the absorption barrier layer system comprises 2, 3, 4, 5, 6, 7, 8, 9, or 10, preferably 2, 3 or 4 barrier coating layers, each barrier layer separated from the other by an intervening polymeric interface layer.

In a preferred embodiment of the present invention, the absorption barrier layer system of the present invention comprises a crosslinked superficial section of the polymeric device, preferably PDMS substrate, and at least one, preferably at least two, preferably at least three, preferably at least four, preferably at least five, preferably at least six, preferably at least seven, preferably at least eight, preferably at least nine barrier coating layers deposited on the polymeric device, preferably the PDMS device, in particular on a crosslinked superficial section of the polymeric device, preferably the PDMS device, and a corresponding number of intervening polymeric interface layers deposited between two adjacent barrier coating layers.

According to a preferred embodiment of the present invention, the absorption barrier layer system comprises one polymeric interface layer deposited on the surface of the polymeric device, in particular pores, wells and/or microchannels, and being coated with one barrier coating layer. Such an absorption barrier layer system is called a single-layer system.

In a preferred embodiment of the present invention the absorption barrier layer system comprises two barrier coating layers, namely a first and a second barrier coating layer, counted from the polymeric device to the surface of the barrier system, separated by an intervening polymeric interface layer, and wherein the first barrier layer is deposited on the surface area of the polymeric device, in particular pores, wells and/or microchannels. Such an absorption barrier layer system is called a double-layer system.

In a furthermore preferred embodiment of the present invention, the absorption barrier layer system comprises three barrier coating layers, namely a first, a second and a third barrier coating layer, counted from the polymeric device to the surface of the barrier system, wherein between the first and the second and between the second and the third barrier coating layer each a polymeric interface layer is deposited and wherein the first barrier layer is deposited on the surface area of the polymeric device, in particular pores, wells and/or microchannels. Such an absorption barrier layer system is called a three-fold layer system.

In a furthermore preferred embodiment of the present invention, the absorption barrier layer system comprises four barrier coating layers, namely a first, a second, a third and a fourth barrier coating layer, counted from the polymeric device to the surface of the barrier system, wherein between the first and the second, between the second and the third, and between the third and the fourth barrier coating layer each a polymeric interface layer is deposited, and wherein the first barrier layer is deposited on the surface of the polymeric device, in particular pores, wells and/or microchannels. Such an absorption barrier layer system is called a four-fold layer system.

Thus, in a preferred embodiment of the present invention the at least one polymeric interface layer is located on the surface of the pores, wells and/or microchannels, on a crosslinked superficial section of the device, located between two barrier coating layers, or at least two polymeric interface layers are located on the surface area of the polymeric device, in particular pores, wells and/or microchannels, or the crosslinked superficial section and between two barrier coating layers.

In a furthermore preferred embodiment, the above identified single-layer, double-layer, three-fold layer or four-fold layer system is provided, wherein the identified polymeric interface layers and barrier coating layers are deposited not directly on the polymeric device but instead on a cross-linked superficial section thereof, the latter thereby forming also part of the absorption barrier layer system.

In a preferred embodiment of the present invention, the absorption barrier layer system of the present invention is transparent. In a preferred embodiment of the present invention, the absorption barrier layer system of the present invention and the top-coating deposited on the surface thereof is transparent.

In the context of the present invention, a "hybrid multi-layered absorption barrier layer system" is a system comprising at least one, preferably two, three or four barrier coating layers, and at least one, preferably two or three, polymeric interface layers, and, optionally, a crosslinked superficial section of the device, preferably wherein the at least one interface layer separates the barrier coating layers from each other, separates the surface of the polymeric device, in particular pores, wells and/or microchannels from the barrier coating layer, separates the crosslinked superficial section of the device from the barrier coating layer, or performs two or three of the functions.

A preferred hybrid multi-layered absorption barrier layer system of the present invention comprises at least one preferably rigid, preferably glass-like, for instance SiO₂-based, barrier coating layer and at least one preferably flexible, preferably polymer-like, for instance polymeric, interface layer. The at least one preferably rigid, preferably glass-like, preferably SiO₂-based, barrier coating layer is mainly responsible for the barrier effect, inhibiting or at least reducing the partitioning of substances from the sample into the polymeric device. The at least one flexible, preferably polymer-like, preferably polymeric, interface layer improves the barrier characteristics during stretching by presenting an extended tortuous path for the partitioning of the substance. As a result, the partitioning of any substance, in particular hydrophobic substance, into the polymeric, preferably PDMS, device will be avoided or significantly reduced. Without being bound by theory, it is believed that stretching of the polymeric, preferably PDMS, device leads to cracks or gaps in the individual barrier coating layers, whereby, however, due to the multi-layer characteristics and the presence of the polymeric interface layers non-alignment of cracks in the polymeric device and/or the barrier coating layers will lead to an extended diffusion path for the substances and thereby reduce their partitioning from the sample into the substrate.

Thus, the present invention in particular provides an improved and advantageous coated polymeric device, preferably microfluidic device, all culture device or membrane which avoids or reduces the partitioning of substances from a sample into the polymeric device, e.g. the PDMS substrate, in particular under circumstances, wherein the polymeric device is subjected to external forces causing stretching and/or elongation of the microfluidic device, in particular stretching or bending, preferably up to an elongation of 30 %. The present invention therefore provides an improved coated polymeric device, in particular microfluidic device, cell culture device or membrane which provides a desired flexibility thereby avoiding effects of substance partitioning into the device itself.

In a preferred embodiment of the present invention, the at least one barrier coating layer has a thickness of 5 to 500 nm, preferably 10 to 200 nm, preferably 50 to 100 nm, preferably 50 to 180 nm, in particular 10 to 150, in particular 20 to 120 nm, preferably 15 to 50 nm.

In a preferred embodiment of the present invention, the polymeric interface layer has a thickness of 5 to 500 nm, preferably 10 to 200 nm, preferably 50 to 100 nm, preferably 50 to 180 nm, in particular 10 to 150, in particular 20 to 120 nm, preferably 15 to 50 nm.

In a preferred embodiment of the present invention, the polymeric device is made from a polymer, preferably PDMS, PMMA (polymethylmethylacrylate), PVC (polyvinyl chloride), COC (cyclic olefine copolymer), PS (polystyrene), PC (polycarbonate), polyimide, polyurethane, polyethylene terephthalate (PET), polyesters, in particular polycaprolactone (PCT), or combination of two or more of the polymers.

In a preferred embodiment of the present invention, the at least one barrier coating layer is a coating layer selected from the group consisting of a SiO₂-based coating layer, a ZnO-based coating layer, an Al₂O₃-based coating layer, a SiCₓO_{y}N_{z}-based coating layer (with x, y and z each being independently from 0 to 4, preferably being 0, 1, 2, 3 or 4), a SiC-based coating layer, (a SiOC-based coating layer, a SiON-based coating layer), a Si₃N₄-based coating layer, a TiO₂-based coating layer, a metallic-based coating layer, in particular Al-based coating layer, or a ceramic-based coating layer.

In a preferred embodiment of the present invention, the at least one barrier coating layer is a SiC_{X}O_{Y}N_{z}- based coating layer, in particular a SiC_{X}O_{Y}N_{z} coating layer, preferably is consisting of SiC_{X}O_{Y}N_{z} (each with x, y and z each being independently from 0 to 4, preferably being 0, 1, 2, 3 or 4).

In a preferred embodiment of the present invention, the at least one barrier coating layer is a SiO₂-based coating layer, in particular a SiO₂ coating layer, preferably is consisting of SiO₂.

In a preferred embodiment of the present invention, the at least one barrier coating layer is a ZnO-based coating layer, in particular a ZnO coating layer, preferably is consisting of ZnO. In a preferred embodiment of the present invention, the at least one barrier coating layer is a Al₂O₃-based coating layer, in particular a Al₂O₃ coating layer, preferably is consisting of Al₂O₃. In a preferred embodiment of the present invention, the at least one barrier coating layer is a TiO₂-based coating layer, in particular a TiO₂ coating layer, preferably is consisting of TiO₂. In a furthermore preferred embodiment the at least one barrier coating layer is a SiC-based coating layer, in particular a SiC coating layer, preferably is consisting of SiC. In a furthermore preferred embodiment of the present invention the at least one barrier coating layer is a SiOC-based coating layer, in particular a SiOC coating layer, preferably is consisting of SiOC. In a furthermore preferred embodiment of the present invention the at least one barrier coating layer is a Si₃N₄-based coating layer, in particular a Si₃N₄ coating layer, preferably is consisting of Si₃N₄. In a preferred embodiment of the present invention the at least one barrier coating layer is a SiON-based coating layer, in particular a SiON coating layer, preferably is consisting of SiON. In a preferred embodiment of the present invention the at least one barrier coating layer is a metallic-based layer, preferably Al. In a preferred embodiment of the present invention the at least one barrier coating layer is a ceramic-based coating layer, in particular a ceramic coating layer, preferably is consisting of ceramics.

Thicknesses of the coating and interface layers can be controlled by ellipsometry and scanning electromicroscopy (SEM) measurements.

In a preferred embodiment of the present invention, the at least one polymeric interface layer and the at least one barrier coating layer are deposited on each other essentially coextensively or completely coextensively. In a furthermore preferred embodiment, the at least one polymeric interface layer and the at least one barrier coating layer are arranged coextensively to each other and are preferably arranged essentially or completely coextensively on an optionally present crosslinked superficial section of the polymeric device.

In a preferred embodiment of the present invention, the surface of the polymeric device, in particular of the pores, wells and/or microchannels, is at least partially, preferably completely covered by an absorption barrier layer system. In particular, preferably at least a part, preferably the complete, wall of the pores, wells and/or microchannels, is covered by the absorption barrier layer system.

In a furthermore preferred embodiment of the present invention, the surface of the absorption barrier layer system, which is preferably formed from the most outwardly located barrier coating layer, is covered with a top coating. A top coating can, preferably, have a thickness from 5 to 500 nm, preferably 50-300 nm, preferably 20 to 100 nm.

In a preferred embodiment, such a top coating is a functional coating of the surface of the absorption barrier layer system, for instance rendering said surface hydrophobic, hydrophilic, aerophob or aerophil. Preferably, chemical groups, such as amino groups, carboxyl groups, thiol groups, phosphor groups or other organyl groups may be linked to the surface such as the provide the top coating. Preferably, the top coating can comprise metal or metal oxide layers such as Al-, Zn-, ZnO-, Al₂O₃-, SiO₂- or TiO₂-layers.

In a preferred embodiment, the top coating may have surface energy from 10 to 180 mJ/m² and/or have a surface roughness (Rₐ) of 0.2 to 50 nm, preferably 1 to 10 nm.

In a preferred embodiment of the present invention, the absorption barrier layer system as disclosed herein consists of the layers and elements being individually and explicitly disclosed herein. Thus, in this particular embodiment, the absorption barrier layer system of the coated polymeric device of the present invention includes no other material layers or elements than those which are explicitly disclosed herein, namely the at least one polymeric interface layer, the at least one barrier coating, and, optionally, the crosslinked superficial section of the substrate.

The present invention also provides a process for preparing a coated polymeric device, in particular a microfluidic device, coated cell culture device, coated membrane according to the present invention comprising
a) providing a polymeric device, preferably a PDMS device, preferably comprising a system of open microchannels, of pores and/or of wells,
b) subjecting the polymeric device, preferably the PDMS device, to at least one CVD process, in particular at least one PECVD process, so as to provide an absorption barrier layer system comprising at least one polymeric interface layer and at least one barrier coating layer and
c) obtaining the coated polymeric device, in particular the coated microfluidic device, coated cell culture device and/or coated membrane, according to the present invention.

In case the polymeric device, in particular microfluidic device, provided in step a) comprising a system of open microchannels is a precursor for obtaining a fully-assembled polymeric device, in particular microfluidic device, then, in a further process step subsequent to step b) the present invention requires assembling the polymeric device, in particular microfluidic device, from the precursor polymeric device, in particular microfluidic device, prepared according to the present invention and either another precursor polymeric device, in particular microfluidic device, according to the present invention or another precursor to prepare the fully-assembled polymeric device, in particular microfluidic device.

In a preferred embodiment of the present invention, after process step a) and prior to step b), the polymeric substrate of step a) is subjected to a further process step axb) which is a crosslinking process so as to provide a crosslinked superficial section of the polymeric device.

Thus, in one preferred embodiment, a process for preparing a coated polymeric device, in particular a coated microfluidic device, a coated cell culture device or a coated membrane, according to the present invention is provided, comprising
a) providing a polymeric device, preferably a PDMS device, preferably comprising a system of open microchannels, of pores and/or of wells,
axb) subjecting the polymeric device of step a) to a crosslinking process, so as to provide a crosslinked superficial section of the polymeric device,
b) subjecting the crosslinked superficial section of the polymeric device obtained in step axb) to at least one CVD process, in particular at least one PECVD process, so as to provide an absorption barrier layer system comprising at least one polymeric interface layer and at least one barrier layer on the crosslinked superficial section of the polymeric device and
c) obtaining the coated polymeric device, in particular the coated microfluidic device, coated cell culture device or coated membrane, according to the present invention.

Thus, in a preferred embodiment of the present invention, prior to carrying out step b) the polymeric device, preferably PDMS device, is subjected to a crosslinking process, so as to provide an absorption barrier layer system comprising a crosslinked superficial section of the polymeric device, preferably the PDMS device, on which, in a preferred embodiment, one or more barrier coating layers and polymeric interface layers are deposited.

In a preferred embodiment, the CVD process, in particular PECVD process, of step b) is repeated 1, 2, 3, 4, 5, 6, 7, 8, 9, 10 or more times, so as to provide one or more barrier coating layers and in addition one or more polymeric interface layers, wherein the polymeric interface layers are deposited on the polymeric device and/or between, that means intervening, two adjacent barrier coating layers, and/or on the crosslinked superficial section of the device.

In a furthermore preferred embodiment of the present invention, the barrier coating layer, preferably the SiO₂-based coating layer, is deposited on the polymeric device by a chemical vapour deposition process (CVD-process), preferably a PECVD process (plasma enhanced chemical vapour deposition), preferably using tetraethyl orthosilicate and O₂ or using silanes, preferably siloxanes, preferably HMDSN or HMDSO, each of them preferably together with N, NH₃, N₂O and/or O₂.

In a preferred embodiment SiOₓN_{y}, Si₃N₄ or SiCₓO_{y}N_{z} (each with x, y, z each being independently from 0 to 4, preferably being 0, 1, 2, 3 or 4) can be prepared by a CVD-process, in particular a PECVD process, using HMDSN (hexamethyldisilazane) optionally, using N, NH₃, N₂O and/or O₂-carrier gas.

In a preferred embodiment, wherein the absorption barrier layer system of the present invention comprises at least two barrier coating layers, in a preferred embodiment these at least two barrier coating layers are made from different materials. The embodiment, thus, provides barrier coating layers with different degrees of hardness.

In a furthermore preferred embodiment of the present invention, the polymeric interface layer is deposited by a CVD-process, in particular a PECVD process, preferably using tetraethyl orthosilicate and O₂ or using silanes, preferably siloxanes, preferably using HMDSO, or parylene.

In a preferred embodiment, the polymeric interface layer is made from plasma polymerized HMDSO, in particular is a polymer layer.

In a preferred embodiment, the HMDSO-layer consists preferably of 45 to 55 at%, preferably 50 at% C, 20 to 30 at%, preferably 25 at% O and 20 to 30 at%, preferably 25 at% Si.

In a furthermore preferred embodiment of the present invention, the CVD process for applying the barrier coating and the interface layer is a PECVD process.

In a furthermore preferred embodiment of the present invention, the PECVD process uses a low pressure plasma method, preferably using a pressure < 1 mbar, and preferably employs the following general conditions:
The layers of the absorption barrier layer system are prepared on the polymeric device in a preferred embodiment by means of a low-pressure plasma method, preferably wherein a plasma is generated from reactive gas by means of a high-frequency discharge between at least two electrodes, which gas contains a suitable starting molecule, for instance HMDSO. Preferably, the gas atmosphere has a low pressure, for example a pressure < 1 mbar, and/or uses process gases for instance O₂, He, Ar or N₂ as well as corresponding starting polymers for the production of the coatings. For the production of silicon-type coatings HMDSO is preferably used as starting molecule.

The gas molecules are ionized, fragmented and actived by means of igniting a high-frequency plasma for example at 13,56 MHZ between two electrodes so that a plasma is formed. Chemical reaction can take place in the plasma phase or on the surface to be coated which reactions lead to covalent binding of the plasma polymer products on the surface to be coated.

In a furthermore preferred embodiment of the present invention, the at least one barrier coating layer has been obtained by atomic layer deposition.

In a preferred embodiment of the present invention, the crosslinking for providing the crosslinked superficial section of the polymeric device may be conducted in a plasma, preferably in a low pressure plasma, that means is a plasma-based, in particular low pressure plasma-based method, for instance using a pressure < 1 mbar, by UV and/or VUV radiation, for instance in a range from 150 to 350 nm. In a preferred embodiment, O₂- plasmas can be used, or He, N₂, NO₂, NO, CO₂, or Ar.

In a preferred embodiment, the plasma based method of crosslinking is conducted using an area of the electrode having a format of DIN A3 and, preferably a power of 50 to 800 W, preferably of 100 W, RF (radio frequency) at 13,56 MHz. In other preferred embodiments, the frequency used can be from preferably 3kHz to 150 kHz, or be 2.4 GHz.

In a preferred embodiment of said crosslinking method step, the O₂, He, N₂, NO₂, NO, CO₂, or Ar gas flow is from 100 to 300 sccm, preferably 200 sccm.

In a preferred embodiment of said crosslinking method step, the pressure is a low pressure, in particular from 0.05 to 1.5 mbar, preferably 0.11 mbar.

In a furthermore preferred embodiment of said crosslinking method step, the treatment time for the plasma based crosslinking method step is from 5 s to 15 min, preferably 5 s to 60 s, preferably 1 min to 10 min.

In a preferred embodiment, the UV-/VUV-radiation of the polymeric device for crosslinking can be done by using UV radiation from excimer lamps like Xe₂* (wavelength at 172nm), XeBr* (wavelength at 282 nm), KrCl* (wavelength at 222 nm), or XeCl* (wavelength at 308 nm), or by using the irradiation from a mercury vapor lamp (wavelength at 254 nm) or using deep UV (DUV) LEDs at wavelength of 265 nm, 280 nm, 285 nm or 300 nm, in general using DUV LEDs ranging from 265 nm - 365 nm, e.g. of Nikkiso.

The irradiation time is approx. 1 - 10 min in dependence of the radiation intensity (in mW/cm²) and the distance of the external irradiation source (lamp).

The present processes provide surfaces of coated polymeric devices, in particular microfluidic devices, cell culture devices or membranes which are very smooth. The present processes also allow the preparation of individual polymeric and barrier mono-layers up to the thickness of only 3 µm. Thus, even very small and narrow pores, wells and/or microchannels having diameters of only one or several µm can be coated with the present process.

The present invention also relates to coated polymeric devices, in particular microfluidic devices, cell culture devices or membranes obtainable according to the present process.

The coated polymeric devices, in particular microfluidic device, cell culture devices or membranes as disclosed or as prepared by the present invention is preferably a flexible and biocompatible device and preferably can be used for numerous applications. For instance, it can be used for the preparation of a microfluidic chip, organ-on-a-chip, as a DNA- or RNA-chip, as an inkjet-head, or can be used as lab-on-a-chip.

The presently provided and the presently prepared coated polymeric device, in particular microfluidic devices, cell culture devices or membranes may also be used for the screening, development or analysis of potential or established drugs, for medical, clinical and forensic analysis, 3D-printing, biological and chemical analysis, environmental monitoring or molecular diagnostic.

In the context of the present invention, a "plasma" is a partially or completely ionised gas and/or vapour, which in addition to ions and electrons contains chemical radicals and a number of electronical exited particles.

In the context of the present invention, "a microfluidic device" is a device comprising in a three-dimensional polymeric substrate, that means on the surface of the substrate or embedded in the substrate, a system of microchannels, in particular at least one microchannel, through which a fluid can pass, preferably several microchannels, preferably connected microchannel, preferably a network of connected microchannels, wherein the at least one microchannel has at least one internal cross-sectional dimension (i.e. depth, width or length) that is less than 1000 µm, in particular has at least one diameter in the diameter range from 0.1 to 990, preferably 0.5 to 900 µm, in particular 0.5 to 800 µm, preferably 1 to 400 µm, preferably 1 to 10 µm, preferably 1 to 5 µm.

A "system of microchannels" herein is also termed "microchannels".

In the context of the present invention, an "open microchannel" is a microchannel, the wall of which does not completely enclose the void of the microchannel along its longitudinal axis and which is being provided on the surface of a microfluidic device or on the surface of a precursor for a microfluidic device, for instance a polymeric sheet prior to bonding, that means assembling, of a microfluidic device.

In the context of the present invention, "a microchannel" can be an open microchannel or a microchannel being embedded in a polymeric substrate.

A microfluidic device comprising a system of embedded microchannels according to the present invention is obtainable from a precursor microfluidic device comprising a system of open microchannels according to the present invention and being obtainable by a process of the present invention.

In the context of the present invention, "a system of pores", herein also termed "pores", means at least one pore, preferably 2, 3, 4 or more pores, in particular a multitude of pores.

In the context of the present invention, the term "a system of wells", herein also termed "wells", means at least one well, in particular 1, 2, 3, 4, or more wells, preferably a multitude of wells.

In the context of the present invention, the surface of a pore, well or microchannel is a wall of the pore, well or microchannel.

The use of the terms "a" and "an" and "the", and similar reference in the context of the present invention are to be construed to cover both a singular and the plural, unless otherwise indicated here and are clearly contradicted by context.

The terms "or/and" and "and/or" referred to and linking at least two subject-matters of an enumeration means that each single subject-matter is individually referred to and that a combination of at least two, preferably all, of said subject-matters contained in the enumeration is individually referred to.

The terms "comprising", "having", "including" and "containing" are to be construed as openended terms, that means including but not limited thereto unless otherwise noted.

In the context of the present invention the terms "comprising", "having", "including" and "containing" also encompass a more limited embodiment, namely includes the meaning of "consisting of", thereby clarifying that solely the elements individually recited are referred to thereby excluding other not specifically mentioned elements.

Recitations of ranges of variations herein are merely attended to serve as a short-hand method of referring individually to each separate value falling within the range, unless otherwise indicated herein. Each separate value is incorporated into the description as if it were individually recited therein. For instance, if a range from 1 to 10 is disclosed, then 1, 2, 3, 4, 5, 6, 7, 8, 9 and 10 are disclosed.

Further preferred embodiments are the subject-matter of the subclaims.

The present invention will be described in more detail by way of the accompanying figures and the examples.

The figures show:
Figure 1
   A schematic drawing (top view) of a microfluidic device comprising a system of microchannels in the polymeric device.
Figure 2
   A schematic drawing (cross sectional view) of a microfluidic device.
Figure 3
   A schematic drawing (cross sectional view) of a microfluidic device comprising a barrier coating system of the present invention.
Figure 4
   A schematic drawing (cross sectional view) of another microfluidic device of the present invention.
Figure 5A to 5D
   Schematic drawings of a single-layer (5A), double-layer (5B), three-fold-layer (5C) and four-fold (5D) layer absorption barrier layer system of the present invention, each on a PDMS device.
Figure 6A to 6D
   Schematic drawings of a single-layer (6A), double-layer (6B), three-fold-layer (6C) and four-fold (6D) layer absorption barrier layer system of the present invention with a top coating, each on a PDMS device.
Figure 7
   A schematic drawing showing the tortuous path of a permeating substance through a hybrid multilayered barrier system of the present invention.
Figure 8
   A light-microscopic (8A) and fluorescence microscopic (8B) image (cross-section) of an untreated non-coated PDMS device having no cross-linked superficial section.
Figure 9
   A light-microscopic (9A) and fluorescence microscopic (9B) image (cross-section) of a coated polymeric device comprising a double-layer absorption barrier layer system of the present invention.
Figure 10

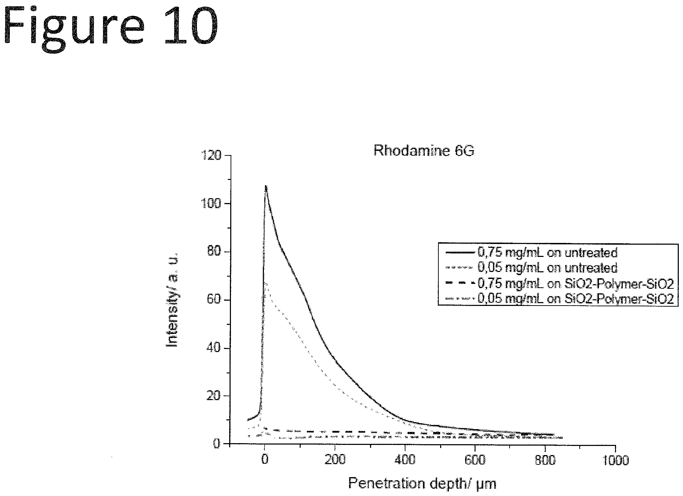

   Figure 10 shows graphically the fluorescence intensity (A.U., arbitrary units) in dependency upon the penetration depth, measured in untreated polymeric devices and polymeric devices comprising an absorption barrier layer system of the present invention after rhodamine 6G application.
Figure 11

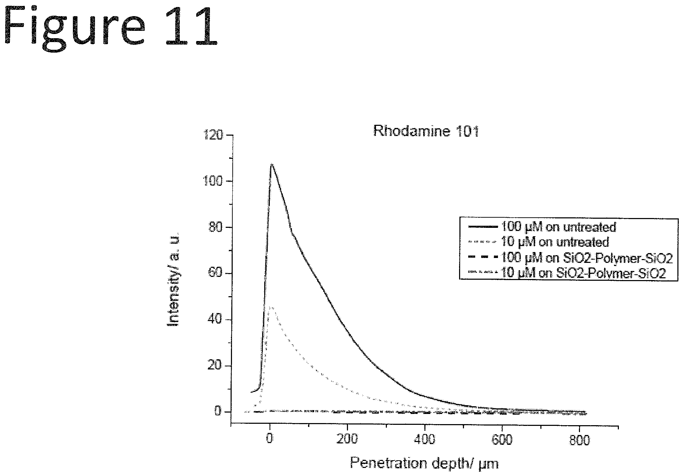

   Figure 11 shows graphically the fluorescence intensity (A.U., arbitrary units) in dependency upon the penetration depth, measured in untreated polymeric devices and polymeric devices comprising an absorption barrier layer system of the present invention after rhodamine 101 application.
Figure 12

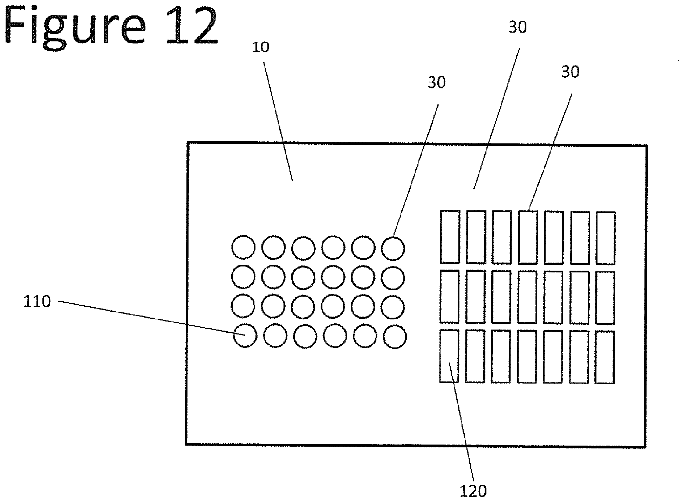

   Figure 12 shows schematically a polymeric device (10) of the present invention comprising wells and pores.

### Example 1 - Structures of microfluidic devices of the present invention

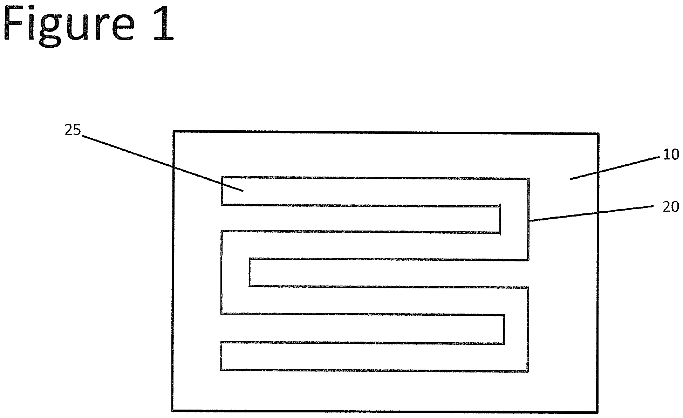

Figure 1 shows a microfluidic device of the present invention in top view comprising a polymeric device (10), made from PDMS, and a system (20) of microchannels (25).

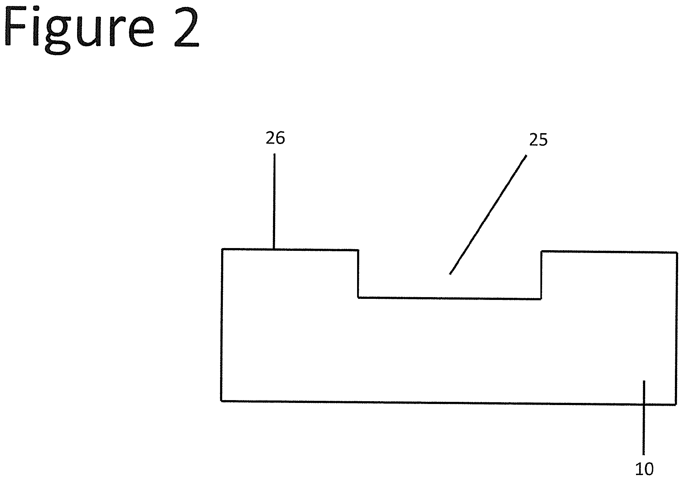

Figure 2 shows in cross-sectional view a microfluidic device with a microchannel (25) located on the surface (26) of a polymeric device (10).

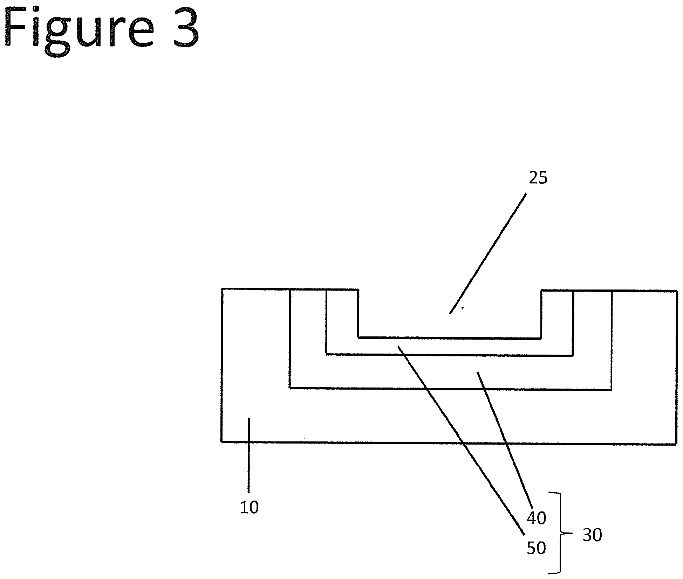

Figure 3 shows, in cross-sectional view, a microfluidic device and a microchannel (25), wherein the surface of the microchannel (25) is formed by an absorption barrier layer system (30) which comprises a polymeric interface layer (40) made by a PECVD process from HMDSO and which is located on the surface of the microchannel (25) and on which a barrier coating layer (50), which is an SiO₂-layer made by a PECVD process using HMDSO and O₂, is deposited thereon, thereby forming the surface of the microchannel (25). In this embodiment, the absorption layer system (30) comprises a polymeric-interface layer (40) deposited on the surface of the microchannel (25) and a barrier coating layer (50) deposited on the polymeric interface layer (40).

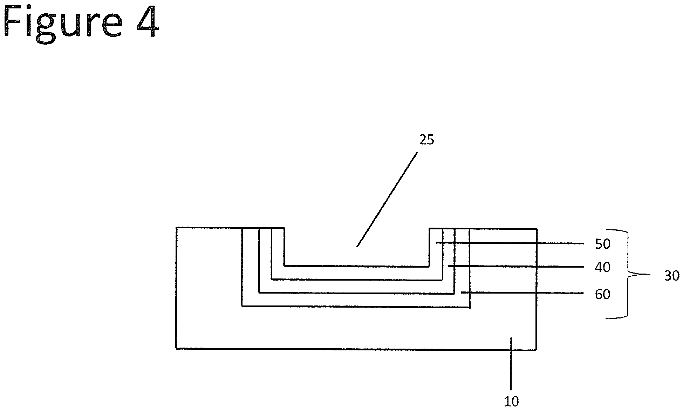

Figure 4 shows essentially the same embodiment as given in Figure 3, except that the polymeric interface layer (40) is deposited on a cross-linked superficial section (60) of the surface of the microchannel (25). In this embodiment, the absorption barrier layer system comprises the cross-linked superficial section (60) made in a plasma process using UV radiation and on which a polymeric interface layer (40) is deposited and on which polymeric interface layer (40), a barrier coating layer (50) is deposited thereon, thereby forming the most outwardly located surface coating of the microchannel (25).

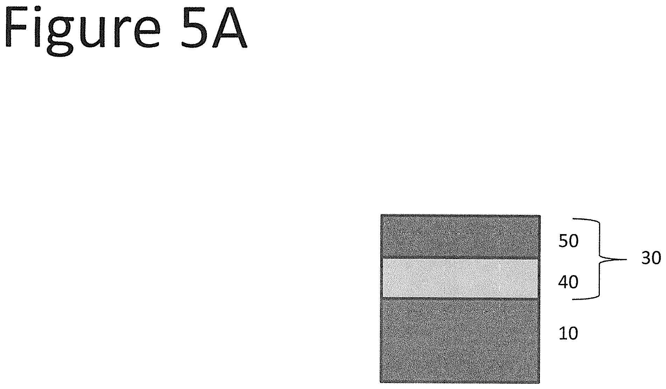

Figure 5A shows schematically the structure of a single-layer absorption barrier layer system (30) of the present invention, comprising a polymeric interface layer (40) deposited on the surface of the substrate (10) or on a non-depicted cross-linked superficial section of the device, and on top of the polymeric interface layer (40) a barrier coating layer (50).

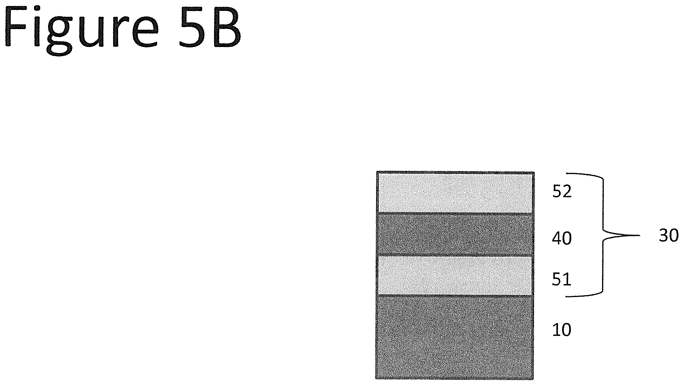

Figure 5B shows an absorption barrier layer system (30) which is a double-layer system comprising on the surface of the device (10) a first barrier coating layer (51), a polymeric interface layer (40) and a second barrier coating layer (52).

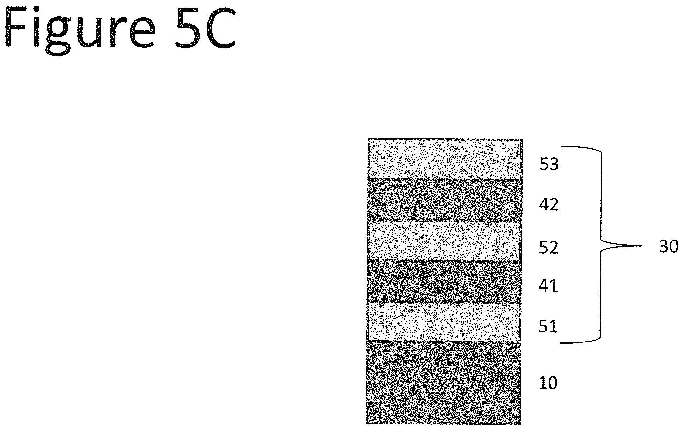

Figure 5C shows an absorption barrier layer system (30), namely a three-fold layer system (30) located on the surface of a microchannel, i.e. on the polymeric device (10), which system comprises a first barrier coating layer (51), a first polymeric interface layer (41), a second barrier coating layer (52), a second polymeric interface layer (42), and a third barrier coating layer (53).

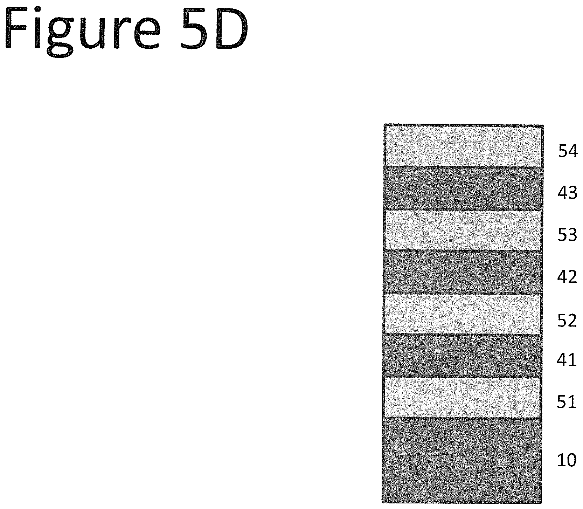

Figure 5D shows an absorption barrier layer system (30), namely a four-fold layer system (30) located on the device (10) which comprises a first barrier coating layer (51), a first polymeric interface layer (41), a second barrier coating layer (52), a second polymeric interface layer (42), a third barrier coating layer (53), a third polymeric interface layer (44) and a fourth barrier coating layer (54).

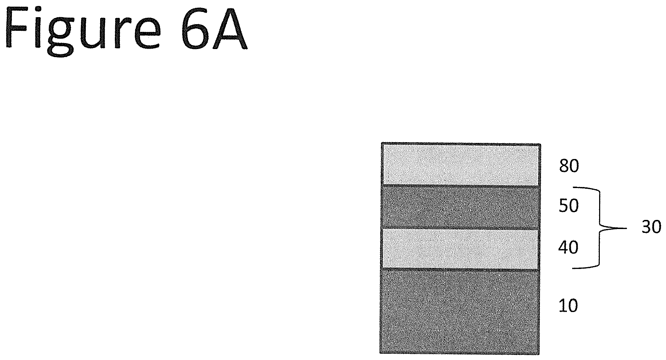

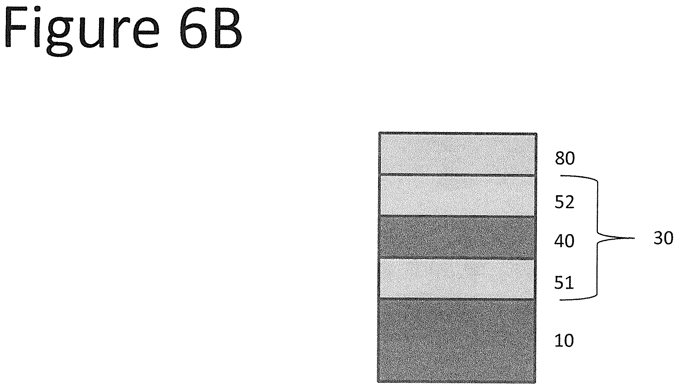

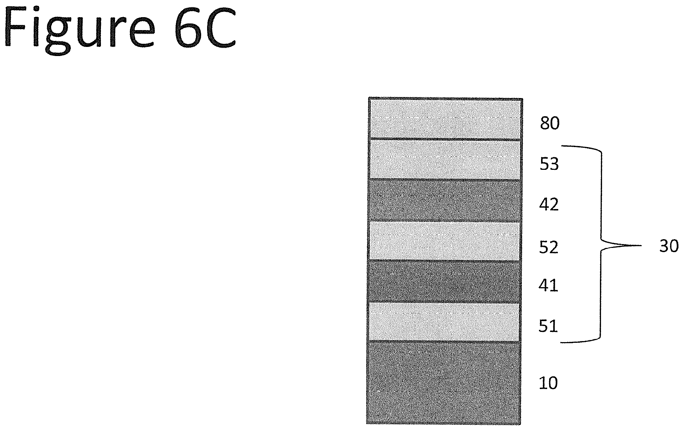

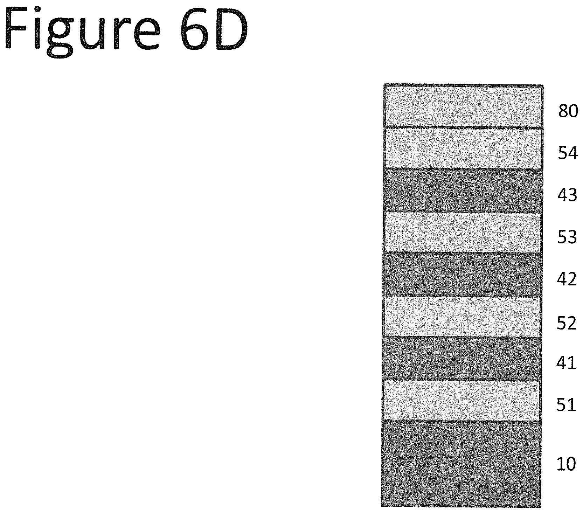

Figures 6A, 6B, 6C and 6D show absorption barrier layer systems (30) as depicted in Figures 5A to 5D except that on each of the most outwardly located surface of said absorption barrier layer systems (30) a top coating (80) is located.

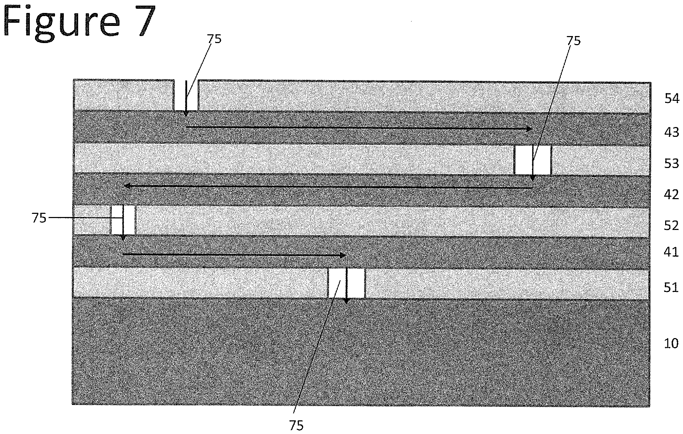

Figure 7 shows a cross-sectional view of an absorption barrier layer system (30) provided on a polymeric device (10). The absorption barrier layer system comprises a first barrier coating layer (51) deposited on the polymeric substrate (10) forming a surface of the microchannel (25), a first polymeric interface layer (41), a second barrier coating layer (52) deposited on the first polymeric interface layer (41), a second polymeric interface layer (42) deposited on the second barrier coating layer (52), a third barrier coating layer (53) deposited on the second polymeric interface layer (42), a third polymeric interface layer (43) deposited on the third barrier coating layer (53) and a fourth barrier coating layer (54) deposited on the third polymeric interface layer (43). The barrier coating layers are rigid barrier coating layers, in particular SiO₂-coating layers, while the polymeric interface layers are polymer-like flexible layers.

Subjecting the device (10) to mechanical stress, for instance stretching or bending, leads to the formation of gaps (75) in the rigid glass-like barrier coating layers (51, 52, 53 and 54). The gaps (75) formed in the different barrier coating layers (51, 52, 53,54) are spatially separated from each other by the more flexible polymeric interface layers (41, 42, 43), thereby leading to an extended torturous pathway (arrow) for any penetrating substance entering the surface of the microchannel towards the direction of the substrate. Thus, it is clear that an extended pathway for substances stemming from the sample into the substrate is provided, reducing or avoiding any absorption of a substance present in the sample in the substrate itself.

Figure 12 shows schematically a polymeric device in the form of a cell culture device (10) comprising a system of pores (110) and a system of wells (120). The complete surface of the device (10) including the walls of the system of pores (110) and of the system of wells (120) is covered with an absorption barrier layer system (30).

### Example 2 - Preparation of a microfluidic device of the present invention

To prepare the present microfluidic PDMS devices, master-wafers are fabricated via standard photolithography. Briefly, layers of photoresist (SU-8 or similar) with defined thickness are obtained via spin coating the resist onto silicon wafers. The photoresist is exposed to UV light through a mask with the desired lateral structures. Before and after exposure to UV light the wafers are placed on hot plates and heated up to defined temperatures. Subsequently, the non-exposed/non-crosslinked areas of the photoresist are removed by immersion of the patterned wafers in photoresist developer. Following a final baking step, the patterned surface is coated with a fluorosilane. The microfluidic PDMS devices are replica molded by pouring uncured PDMS with application-specific ratio of a curing agent to a prepolymer onto the master-wafers, which are subsequently cured at elevated (50-90°C) temperatures for multiple (2-10) hours. The final PDMS devices are obtained by peeling the cured molds from the wafer and cutting them into individual modules, in which access holes are punched. The modules are then bonded to glass slides via exposure to oxygen plasma, followed by a baking step.

Subsequently, the absorption barrier layer system is applied in a reactor of an area of DNA3 using the following process parameters.

For the SiO₂ barrier coating layer:
power: 350 W
HMDSO flow: 7 sccm
O₂ flow: 160 sccm
pressure: 0.11 - 0.12 mbar
treatment time 2.5 min for approx. 200 nm
Deposition rate approx. 70 nm / min

For the plasma polymerized HMDSO-interface layer:
power: 140 W
HMDSO-flow 7 sccm
Ar or N₂-flow: 100 sccm
pressure: 0.09-0.2 mbar
treatment time 5 min for approx. 500 nm - 600nm

All plasma processes in this example are radio frequency (RF) plasmas at 13.56 MHz.

The following tables I and II show the results of a chemical analysis obtained by ESCA (electron microscopy for chemical analysis) for various glass like SiO₂ barrier coating layers (table I) and plasma polymerized HMDSO interface layers (table II) prepared using various different process conditions according to the present invention in comparison to a PDMS reference (table I).

### ESCA (electron microscopy for chemical analysis) results for various glass like SiO₂ barrier coating layers:

**Table I:**

| Element E_{B} (eV) | C3 COH 286,5 | C2 COH 285,5 | C1 CH 284,6 | O 534,2 | O 533,3 | O 532,4 | Si SiO₂ 103,5 | Si organic 102,1 |
|---|---|---|---|---|---|---|---|---|
| | elemental composition in atom% | | | | | | | |
| PDMS reference | 0,8 | 5,2 | 42,8 | | 4,2 | 23,6 | 9,0 | 14,5 |
| PDMS reference 30 s sputtered | | 39,8 | | | 3,8 | 27,2 | 29,2 | |
| PDMS O₂ plasma | 0,6 | 2,3 | 19,8 | 2,6 | 22,4 | 25,8 | 19,8 | 6,8 |
| PDMS O₂-Plasma 30 s sputtered | | 1,2 | 17,8 | 3,8 | 20,6 | 26,7 | 22,9 | 7,1 |
| PDMS one SiO₂ plasma coating | 0,6 | 1,5 | 17,9 | 2,6 | 22,5 | 25,9 | 25,0 | 4,1 |
| PDMS one SiO₂ plasma coating 30 s sputtered | | 1,1 | 7,3 | 3,6 | 26,7 | 30,5 | 29,4 | 1,5 |
| PDMS repetition of one SiO₂ plasma coating | 0,6 | 1,9 | 12,5 | 5,5 | 50,9 | | 27,0 | 1,6 |
| PDMS repetition of one SiO₂ plasma coating 90 s sputtered | - | - | 2,8 | 5,4 | 59,8 | | 31,4 | 0,7 |

### ESCA results for polymeric interface layers:

**Table II:**

| Element E_{B} (eV) | C3 COH 287,1 | C2 COH 285,8 | C1 CH 284,6 | N 399,8 | N 398,3 | O total | Si SiO2 103,5 | Si organi c 102,2 |
|---|---|---|---|---|---|---|---|---|
| | elemental composition in atom% | | | | | | | |
| Plasma polymerized interface layer HMDSO with N₂ | 1,3 | 4,5 | 47,2 | 0,6 | 1,6 | 23,5 | - | 21,4 |
| Plasma polymerized interface layer HMDSO with Ar | 1,1 | 3,3 | 46,6 | - | - | 25,9 | - | 23,1 |

The optionally present crosslinked superficial section of the polymer device is prepared using the following process parameters of a plasma-based process:

### Plasma UV:

Area of the electrode: DINA3
Power: 100 W RF (13.56 MHz)
O₂ gas flow: 200 sccm (optional N₂, NO₂, NO, CO₂, He or Ar)
Pressure: 0.11 mbar
Treatment time: 10 min.

The irradiation of the polymeric device for crosslinking is carried out using UV radiation from excimer lamps like Xe₂* (wavelength at 172nm), XeBr* (wavelength at 282 nm), KrCl* (wavelength at 222 nm), or XeCl* (wavelength at 308 nm), or by using the irradiation from a mercury vapor lamp (wavelength at 254 nm) or using deep UV (DUV) LEDs at wavelength of 265 nm, 280 nm, 285 nm or 300 nm (in general using DUV LEDs ranging from 265 nm - 365 nm) (Nikkiso).

The irradiation time is approx. 1 - 10 min in dependence of the radiation intensity.

### Example 3 - Penetration analysis

Penetration analysis was performed on PDMS devices in form of slabs which have been prepared using a 1:10 w/w ratio of curing agent to prepolymer that were cured for 4 hours at 70°C in a convection oven.

Non-treated, i.e. non-coated, PDMS devices and coated PDMS devices of the present invention comprising an absorption barrier layer system were incubated in 600 µl of Rhodamine 6G and Rhodamine 101 solutions at different concentrations. After 60 min incubation in physiological environment, the Rhodamine solutions were aspirated and the samples rinsed in i) 600µl PBS, ii) 1200µl PBS and iii) 60µl DI Water. Multiple cross-sections were prepared by cutting the samples using a razor blade. The cross-sections were then imaged using a fluorescence microscope maintaining the exact same settings for all cross-sections and samples. Average fluorescence intensity in dependency upon the penetration depths was analysed using ImageJ "plot profile" tool.

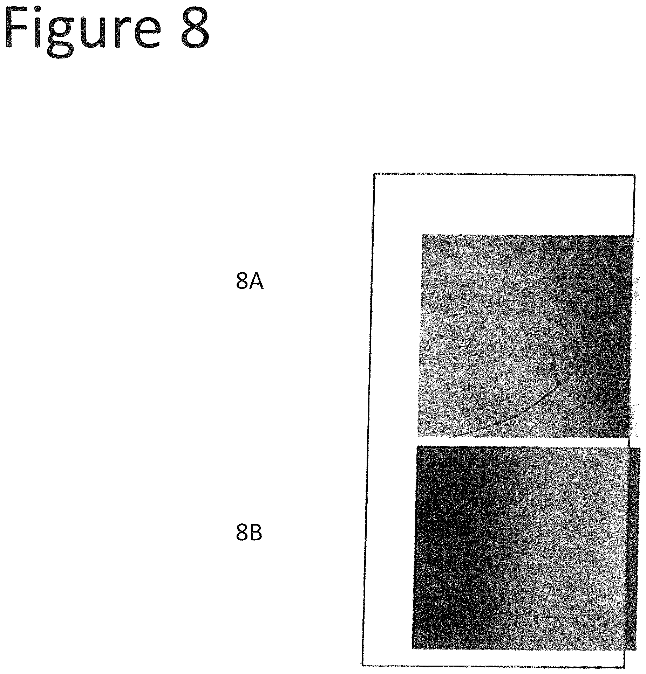

Figure 8A shows a light-microscopic image of a cross-section through a non-treated, that means non-coated, PDMS device having no crosslinked superficial section, which has been incubated for 60 min with rhodamine 6G solution prior to the analysis.

Figure 8B shows a fluorescence microscopic image thereof, clearly indicating the significant penetration of the rhodamine 6G solution into the device.

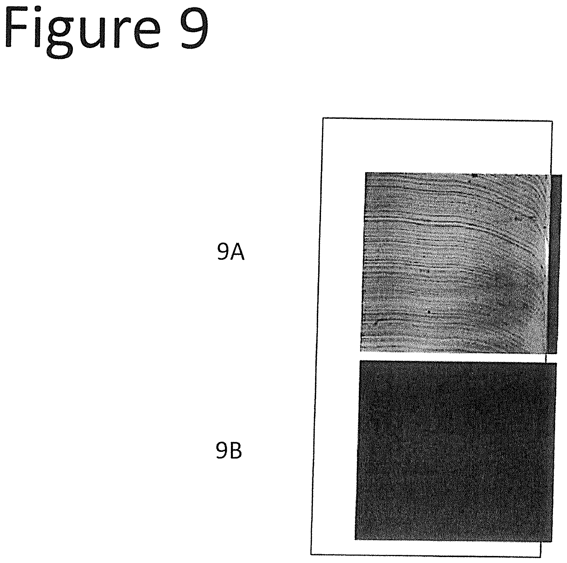

Figure 9A shows a light-microscopic image of a cross-section of a microfluidic device according to the present invention, comprising a double-layer absorption barrier layer system, which comprises a first barrier coating layer on the polymeric device, a polymeric interface layer deposited thereon and a second barrier coating layer coated thereon, which has been incubated for 60 min with rhodamine 6G solution prior to the analysis.

Figure 9B shows a fluorescence microscopic image thereof, clearly indicating that even after 60 minutes of rhodamine 6G incubation no permeation of the solution into the polymeric device occurred.

Figure 10 shows the fluorescence intensity of rhodamine 6G in dependency upon the penetration depths in the polymeric device for two different concentrations of rhodamine 6G (0,05 and 0,75 mg/ml) on a non-treated, i.e. non-coated polymeric device having no crosslinked superficial section according to figure 8 and on a coated polymeric device of the present invention comprising an absorption barrier layer system according to figures 5B and 9 (first barrier layer: SiO₂, polymeric interface layer, second barrier coating layer: SiO₂). It is clearly evident that there is no penetration into the polymeric device being covered with the absorption barrier system of the present invention, while in non-treated substrates a significant penetration into the polymeric device occurred.

Figure 11 shows the fluorescence intensity of rhodamine 101 in dependency upon the penetration depths in the polymeric device for two different concentrations of rhodamine 101 (10 mM, 100 mM) on a non-treated, i.e. non-coated polymeric device having no crosslinked superficial section according to figure 8 and on a coated polymeric device of the present invention comprising an absorption barrier layer system according to figures 5B and 9 (first barrier layer: SiO₂, polymeric interface layer, second barrier coating layer: SiO₂). It is clearly evident that there is no penetration into the polymeric device being covered with the absorption barrier system of the present invention, while in non-treated polymeric devices a significant penetration into the polymeric device occurred.

## Claims

1. A coated polymeric device comprising on at least a part of the surface of a polymeric device (10) an absorption barrier layer system (30), wherein the absorption barrier layer system (30) comprises at least one polymeric interface layer (40) and at least one barrier coating layer (50).

2. The coated polymeric device of claim 1, which comprises at least one topographical structure.

3. The coated polymeric device of claim 2, which topographical structure is a system (20) of microchannels (25), a system of wells or a system of pores.

4. The coated polymeric device of claim 3, which is a microfluidic device, a cell culture device or a membrane.

5. The coated polymeric device of claim 4, which is a microfluidic device, wherein the topographical structure is a system (20) of microchannels (25)and wherein at least a part of the surface of the microchannels (25) is formed by the absorption barrier layer system (30), wherein the absorption barrier layer system (30) comprises at least one polymeric interface layer (40) and at least one barrier coating layer (50).

6. The coated polymeric device according to anyone of claims 1 to 5, wherein the absorption barrier layer system (30) comprises a crosslinked superficial section (60) of the polymeric device (10).

7. The coated polymeric device according to anyone of claims 1 to 6, wherein the at least one polymeric interface layer (40) is located between two barrier coating layers (50), between the surface of the polymeric device and a barrier coating layer (50) and/or between a crosslinked superficial section of the polymeric device (60) and a barrier coating layer (50).

8. The coated polymeric device according to anyone of claims 1 to 7, wherein the absorption barrier layer system (30) comprises a crosslinked superficial section (60) of the polymeric device (10), at least one polymeric interface layer (45) deposited on the crosslinked superficial section (60) and at least one barrier coating layer (50) deposited on the polymeric interface layer.

9. The coated polymeric device according to anyone of the preceding claims, wherein the absorption barrier layer system (30) comprises a first barrier coating layer (51), a polymeric interface layer (40) and a second barrier coating layer (52).

10. The coated polymeric device according to anyone of the preceding claims, wherein the absorption barrier layer system (30) comprises a first barrier coating layer (51), a first polymeric interface layer (41), a second barrier coating layer (52), a second polymeric interface layer and a third barrier coating layer.

11. The coated polymeric device according to anyone of the preceding claims, wherein the absorption barrier layer system (30) comprises a first barrier coating layer (51), a first polymeric interface layer (41), a second barrier coating layer (52), a second polymeric interface layer (42), a third barrier coating layer (53), a third polymeric interface layer (43) and a fourth barrier coating layer (54).

12. The coated polymeric device according to anyone of the preceding claims, wherein the at least one barrier coating layer (50) is a SiO₂-, a SiCₓO_{y}N_{z}- (with x, y and z each being independently from 0 to 4, preferably being 0, 1, 2, 3 or 4), SiC-, SiOC-, Si₃N₄-, SiON-, Al₂O₃-, TiO₂-, ZnO-, metal- or ceramic-based coating layer.

13. The coated polymeric device according to anyone of the preceding claims, wherein the at least one barrier coating layer (50) and the at least one polymeric interface layer (40) have been deposited on the polymeric device by a CVD process, in particular PECVD.

14. The coated polymeric device according to anyone of the preceding claims, wherein the SiO₂-based coating layer has been deposited on the polymeric device (25) by a CVD process, in particular PECVD process, using HMDSO or HMDSN and, optionally, O₂.

15. The coated polymeric device according to anyone of the preceding claims, wherein the polymeric interface layer (40) has been deposited on the polymeric device by a CVD process, in particular PECVD process, using HMDSO, HMDSN, or parylene.

16. The coated polymeric device according to anyone of claims 2 to 11, wherein the process to obtain the crosslinked superficial section is a plasma process employing UV/VUV radiation.

17. The coated polymeric device according to anyone of the preceding claims, wherein the barrier coating layer has been obtained by atomic-layer-deposition.

18. The coated polymeric device according to anyone of the preceding claims, wherein the surface of the absorption barrier layer system (30) is covered with a top coating (80).

19. The coated polymeric device according to anyone of the preceding claims, wherein the at least one barrier coating layer (50) and/or the polymeric interface layer (40) has a thickness of 10 to 500 nm.

20. The coated polymeric device according to anyone of the preceding claims, wherein the polymeric device (10) is made from PDMS (polydimethylsiloxane).

21. The coated polymeric device according to anyone of the preceding claims, wherein the coated polymeric device (100) is a microfluidic chip, an organ-on-a-chip, a lab-on-a-chip, a RNA-chip, a DNA-chip or an inkjet printhead.

22. A process for preparing a coated polymeric device according to anyone of the preceding claims, comprising
a) providing a polymeric device (10), preferably comprising a system (20) of pores, wells and/or open microchannels (25),
b) subjecting the polymeric device (10) of step a) to at least one CVD process, in particular at least one PECVD process, so as to provide an absorption barrier layer system (30) comprising at least one polymeric interface layer (40) and at least one barrier coating layer (50) and
c) obtaining the coated polymeric device (100).

23. The process of claim 22, comprising as a further process step axb), prior to step b), subjecting the polymeric device (10) of step a) to a crosslinking process so as to provide a crosslinked superficial section of the polymeric device (10).
